# EUROPÄISCHE PATENTSCHRIFT

(11) **EP 1 664 705 B1**
(45) Veröffentlichungstag und Bekanntmachung des Hinweises auf die Patenterteilung: **17.04.2013**
(21) Anmeldenummer: 04761911.9
(22) Anmeldetag: 10.09.2004
(51) Int. Cl.: G01L 9/00

(54) **MEHRSCHICHTIGES PIEZOELEKTRISCHES MESSELEMENT UND EIN DRUCK- ODER KRAFTSENSOR UMFASSEND EIN SOLCHES MESSELEMENT**
MULTILAYER PIEZOELECTRIC MEASURING ELEMENT, AND PRESSURE SENSOR OR FORCE SENSOR COMPRISING SUCH A MEASURING ELEMENT
ELEMENT DE MESURE PIEZOELECTRIQUE MULTICOUCHE ET CAPTEUR DE FORCE OU DE PRESSION EQUIPE D'UN ELEMENT DE MESURE DE CE TYPE

(30) Priorität: 17.09.2003 CH 158503
(43) Veröffentlichungstag der Anmeldung: 07.06.2006
(73) Patentinhaber: Kistler Holding AG, 8408 Winterthur (CH)
(72) Erfinder: CAVALLONI, Claudio, CH-8105 Regensdorf (CH); VOLLENWEIDER, Kurt, CH-8457 Humlikon (CH); SOMMER, Roland, CH-8472 Seuzach (CH)
(86) Internationale Anmeldenummer: PCT/CH2004/000571
(87) Internationale Veröffentlichungsnummer: WO 2005/026678

(56) Entgegenhaltungen:
- EP-A- 1 283 552
- AT-B- 382 968
- DE-A- 3 838 014

## Beschreibung

Die Erfindung betrifft ein piezoelektrisches Messelement bestehend aus mindestens zwei piezoelektrischen Kristallen mit Transversaleffekt zum Messen von axial angreifenden Kräften und/oder Drücken und ein Druck- oder Kraftsensor, umfassend ein solches Messelement.

Piezoelektrische Kristalle werden vielerorts in Sensoren verwendet zum Messen von Kräften, Drücken, Beschleunigungen, Dehnungen und Momenten oder Kombinationen davon. Dafür werden beispielsweise Kristalle mit Transversaleffekt in dünne Platten oder Stäbe geschnitten. Beim Einsatz in der Messtechnik werden solche dünnen Platten oder Streifen beispielsweise einer axial angreifenden Kraft ausgesetzt, also einer Kraft auf zwei gegenüberliegenden Stirnflächen einer Platte oder eines Streifens. Handelt es sich dabei um einen Kristall mit Transversaleffekt, so sammelt sich auf den beiden grossen Seitenflächen der Platten oder Streifen unter Krafteinwirkung eine elektrische Ladung an. Auf elektrisch leitenden Schichten, sogenannten Elektroden, welche auf diesen beiden Seitenflächen angebracht sind und keinen elektrischen Kontakt zueinander aufweisen, werden diese Ladungen gesammelt und mit der entsprechenden Vorrichtung im Sensor weitergeleitet. Ein geeignetes Gerät erfasst schliesslich das durch diese Ladungen erzeugte Signal vom Sensor, wodurch Informationen über die Kraft gewonnen werden können. Die Polarisation beschreibt dabei die Richtung von der unter Krafteinfluss jeweils negativ zu der jeweils positiv geladenen Elektrode.

Solche Messelemente und Sensoren sind hinreichend bekannt und beispielsweise in der 1988 veröffentlichten Publikation "PIE-ZOXIDE (PXE)" von VALVO, einem Unternehmensbereich der Philips GmbH, Essen, oder 2002 in "Piezoelectric Sensorics", von G. Gautschi, veröffentlicht durch den Springer Verlag, beschrieben.

Andere Dokumente wie z.B. die Dokumente DE3838014 oder EP1283552 offenbaren ein piezoelektrisches Messelement bestehend aus mindestens zwei piezoelektrischen Kristallen mit Transversaleffekt zum Messen von axial angreifenden Kräften und/oder Drücken.

Entscheidend für die Güte eines Sensors ist, dass jeder der Kristalle senkrecht und zentriert parallel zur Achse des Sensors eingebaut wird. Eine leichte Kipplage resultiert in eine Fehlmessung oder in einen Bruch des Kristalls unter Einfluss der später auftretenden Kräfte.

Die Empfindlichkeit eines solchen Sensors ist proportional zum Verhältnis von Stablänge zu Stabdicke des Kristalls. Dabei ist die Länge des Stabes definiert durch den Abstand der Kraft einleitenden Stirnflächen und die Dicke durch den Abstand der Seitenflächen, an denen sich die Ladungen unter Krafteinfluss ansammeln. Je dünner ein Kristall ist, desto höher ist demnach seine Empfindlichkeit bei gleicher Länge. Andererseits ist die maximale Belastbarkeit von dünnen Platten geringer als von dicken Platten, da sie leichter brechen.

Um eine hohe Empfindlichkeit bei gleichzeitig hoher maximaler Belastbarkeit zu schaffen, können mehrere dünne Kristalle in denselben Sensor eingebaut werden. Die maximale Belastbarkeit des Sensors vervielfacht sich dadurch um die Anzahl der eingesetzten Kristalle, während die Empfindlichkeit dieselbe ist wie unter Verwendung eines einzelnen Kristalls derselben Dicke. Unter Berücksichtigung des Kraftnebenschlusses wird die Empfindlichkeit allerdings höher, weil die Steifigkeit der Summe der Kristalle um die Anzahl der Kristalle erhöht wird.

Eine bekannte Anordnung besteht aus drei Kristallen, die den Querschnitt von Kreissegmenten oder Rechtecken aufweisen. Diese sind in einem runden Sensor derart angeordnet, dass sie mittig ein Dreieck aufweisen. Solche Anordnungen sind beispielsweise aus der CH 392 103 bekannt.

Eine weitere bekannte Anordnung verwendet vier nebeneinander beabstandet angeordnete dünne Kristallplatten mit derselben Länge.

Die Montage, speziell die Zentrierung der Kristalle, ist in diesen Anordnungen mehrfacher Kristalle allerdings noch entsprechend schwieriger.

Bei der Montage muss zudem in diesen beiden Fällen darauf geachtet werden, dass beide Elektroden jedes Kristalls einwandfrei mit den Leitungen im Sensor verbunden sind.

### Kurze Beschreibung der Erfindung

Die Aufgabe der vorliegenden Erfindung ist es, ein eingangs erwähntes piezoelektrisches Messelement zu beschreiben, das sich einfach in einen Sensor zentrieren und anschliessen lässt. Eine weitere Aufgabe besteht darin, einen Sensor umfassend ein solches Messelement zu beschreiben.

Die Aufgabe wird erfindungsgemäss gelöst durch die Merkmale der unabhängigen Patentansprüche.

Erfindungsgemäss werden die Kristalle mit Transversaleffekt mit jeweils entgegengerichteter Polarisation mittels einer seitlichen Elektrode aneinander befestigt.

Vorzugsweise werden dünne Kristalle verwendet, um die Empfindlichkeit des Messelementes zu erhöhen. Zwischen benachbarten Kristallen befindet sich jeweils eine Elektrode, durch welche die beiden Kristalle aneinander befestigt sind. Dadurch entsteht, wenn n Kristalle aneinander verbunden sind, ein einziges mehrschichtiges Messelement, das n-mal so belastbar ist, wie ein einzelner Kristall. Vorzugsweise laufen die Elektroden alternierend in die beiden Kraft aufnehmenden Stirnflächen der Kristalle über. Die Elektroden sind derart miteinander verbunden, dass dem Messelement bei axialer Krafteinleitung ein entsprechendes Kraftsignal entnommen werden kann. Solche Messelemente lassen sich kostengünstig aus Wafern herstellen. Ein so entstandenes kompaktes, mehrschichtiges Messelement lässt sich leicht in einen Sensor, insbesondere in einen Kraft- oder Drucksensor, einbauen und zentrieren, ohne dass die Gefahr einer Kipplage entsteht, da das Messelement eine n-mal breitere Grundfläche aufweist als die Stirnfläche eines einzelnen Kristalls. Solche Sensoren zeichnen sich durch eine hohe Belastbarkeit und eine hohe Empfindlichkeit aus und sind zudem Dank der einfachen Herstellung und Montage der darin eingebrachten Messelemente kostengünstig.

### Detaillierte Beschreibung der Erfindung

Die Erfindung wird unter Verwendung der folgenden Zeichnungen erläutert. Es zeigen
- Fig. 1: Schematische perspektivische Darstellung eines wenig empfindlichen piezoelektrischen Kristalls nach dem Stand der Technik;
- Fig. 2: Schematische perspektivische Darstellung eines hoch empfindlichen piezoelektrischen Kristalls mit niedriger maximaler Belastbarkeit nach dem Stand der Technik;
- Fig. 3: Schematische Darstellung eines hoch empfindlichen piezoelektrischen Messelements mit hoher maximaler Belastbarkeit nach dem Stand der Technik in perspektivischer Seitenansicht (a) und in Aufsicht (b);
- Fig. 4: Schematische Darstellung eines weiteren hoch empfindlichen piezoelektrischen Messelements mit hoher maximaler Belastbarkeit nach dem Stand der Technik in perspektivischer Seitenansicht (a) und in Aufsicht (b);
- Fig. 5: Schematische perspektivische Darstellung eines erfindungsgemässen hoch empfindlichen piezoelektrischen Messelements (a) von oben und (b) von unten her betrachtet;
- Fig. 6: Schematische perspektivische Darstellung eines Wafers für erfindungsgemässe hoch empfindliche piezoelektrische Messelemente;
- Fig. 7: Schematische perspektivische Darstellung eines Teil eines Wafers für erfindungsgemässe hoch empfindliche piezoelektrische Messelemente.

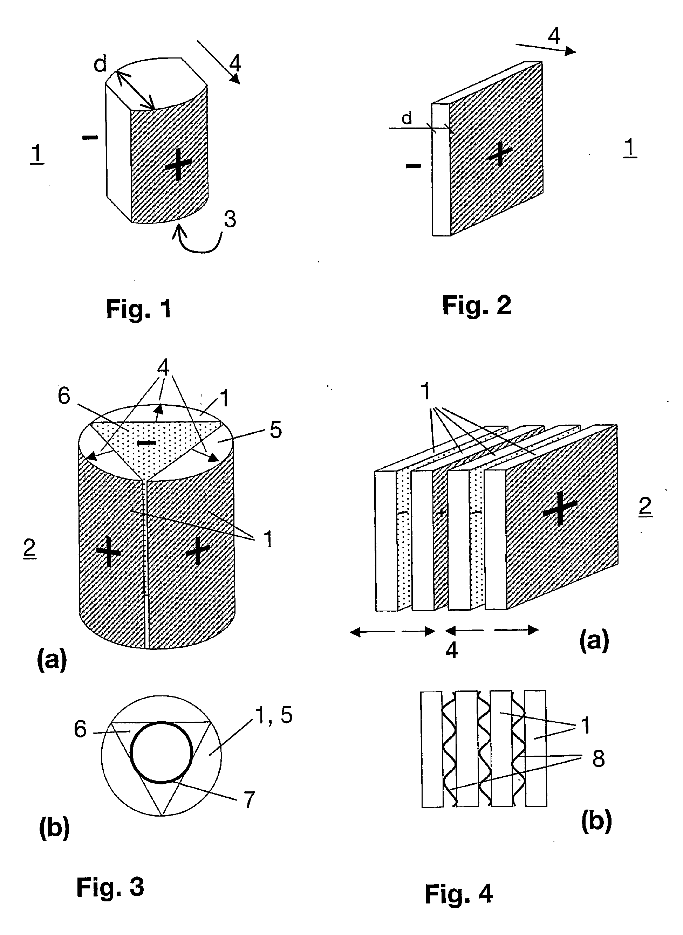

In den Figuren 1 bis 5 zeigt die Pfeilrichtung jeweils die Richtung der Polarisation 4 eines piezoelektrischen Kristalls an, von minus zu plus. Die sich unter Krafteinfluss positiv (+) oder negativ (-) aufladenden Flächen der Kristalle sind mit Elektroden beschichtet. Die sich unter Krafteinfluss positiv aufladenden Elektroden sind jeweils schraffiert und mit einer durchgehenden Umrandungslinie dargestellt; die sich unter Krafteinfluss negativ aufladenden Elektroden sind jeweils gepunktet und mit einer gepunkteten Umrandungslinie dargestellt. Polarisationsrichtungen und somit auch positive und negative Ladungen wurden zur Darstellung willkürlich gewählt und können in jeder Figur umgekehrt resp. ausgetauscht werden.

Fig. 1 zeigt das Abbild eines bekannten einfachen piezoelektrischen Messelementes 1 mit Transversaleffekt. Die in dieser Ausführung grosse Stirnfläche 3 ist vorteilhaft zur einfachen Zentrierung beim Einsetzen in ein Sensorgehäuse. Da die Empfindlichkeit proportional zur mittleren Dicke d des Kristalls ist, ist diese nicht sehr hoch.

Um die Empfindlichkeit zu erhöhen, kann der Kristall 1 dünner ausgestaltet werden. In der Fig. 2 ist ein solcher, ebenfalls bekannter Kristall 1 in Form einer dünnen Platte dargestellt. Die höhere Empfindlichkeit durch die geringe Dicke d reduziert allerdings die Einfachheit des Zentrierens beim Einbauen in einen Sensor. Zudem ist die maximale Belastbarkeit eingeschränkt, da ein solch dünner Kristall 1 leicht bricht.

In der Figur 3 (a) und (b) ist ein bekanntes Messelement 2 dargestellt, bestehend aus drei gleich langen Kristallen 1. Diese weisen eine Querschnittsfläche 5 eines Kreissegments auf und sind derart angeordnet, dass sie in ein rundes Sensorgehäuse gestellt werden können, wobei mittig eine Dreiecksfläche 6 frei bleibt. Die Elektroden auf den nach innen zugewandten Flächen sammeln unter Krafteinfluss alle dieselbe Ladung, welche in dieser Ausführungsform durch eine elektrisch leitende Spiralfeder 7, dargestellt in Fig. 3b, abgenommen wird. Die Ladung der Elektroden auf der Aussenseite der Kristalle wird durch die Hülse des runden Sensorgehäuses abgenommen, an welches die Spiralfeder 7 die Kristalle 1 drückt. Ein solches Messelement 2 zeichnet sich durch seine hohe Belastbarkeit und hohe Empfindlichkeit aus. Die Herstellung und Montage mit der Zentrierung bleibt allerdings sehr aufwändig.

Die in der Fig. 4 (a) und (b) dargestellte bekannte Ausführung eines Messelementes 2 weist dieselben Vor- und Nachteile auf, wie die Ausführung der Figur 3. Hier sind beispielsweise vier Kristalle 1 in Form von Platten mit gleicher Höhe beabstandet nebeneinander angeordnet mit jeweils entgegengesetzter Polarisationsrichtung 4. Zur Ladungsabnahme wird jeweils zwischen zwei benachbarten Kristallen 1 eine wellblechförmige Feder 8 eingesetzt, wie dies in Fig. 4b dargestellt ist. Eine solche Feder 8 gewährleistet stets einen guten Kontakt für die Ladungsabnahme.

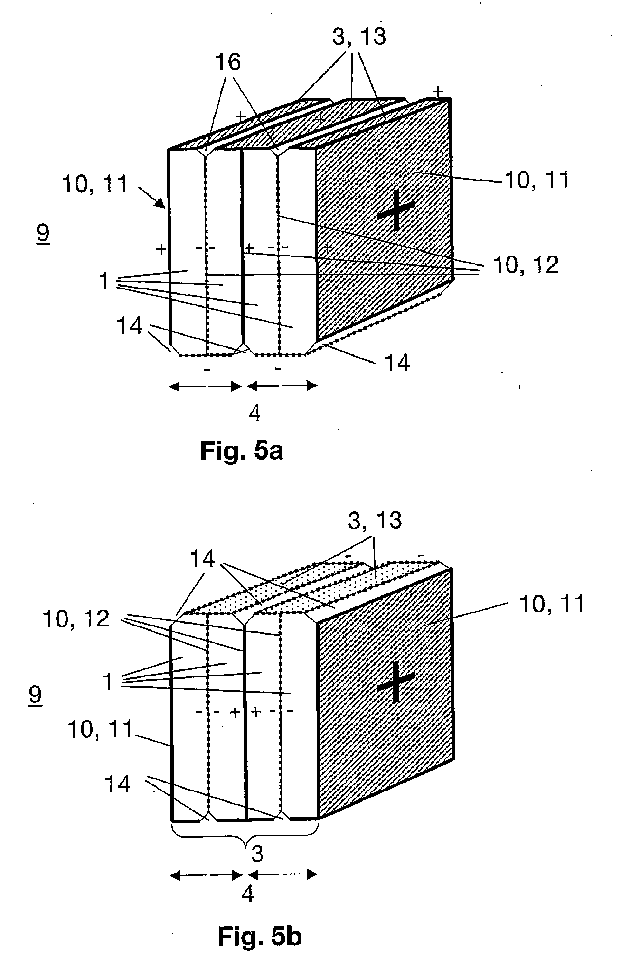

Die Figuren 5a und 5b stellen eine erfinderische Ausführungsform eines Messelementes 9 dar, von zwei Seiten her, welche jeweils um 180° zueinander vertikal gedreht sind. Dieses schematisch dargestellte Messelement 9 besteht aus mindestens zwei direkt nebeneinander angeordneten piezoelektrischen Kristallen 1 mit Transversaleffekt. Die Kristalle 1 in dieser Ausführungsform sind vorzugsweise nicht dicker als 0.5 mm und vorzugsweise als Platten ausgebildet. Alle sich unter Krafteinfluss elektrisch aufladbaren Seitenflächen sind mit einer seitlichen Elektrode 10 beschichtet. Abgesehen von den beiden abschliessenden seitlichen Elektroden 11 verbinden die anderen mittleren Elektroden 12 jeweils zwei benachbarte Kristalle 1 fest miteinander. Die Verbindung durch die Elektrode muss so fest sein, dass sie sich unter der maximalen Last, welcher das Messelement 9 ausgesetzt werden soll und im gesamten für das Messelement zugelassenen Temperaturbereich, nicht löst. Diese Verbindung kann beispielsweise mittels Bonden, Löten oder Thermokompression erreicht worden sein. Wichtig ist allerdings, dass zwei benachbarte Kristalle 1 jeweils mit entgegengesetzten Polarisationsrichtungen 4 angeordnet sind. Insbesondere können Kristalle verwendet werden, die einen von der Temperatur unabhängigen Effekt erzielen.

Zur Ladungsabnahme werden vorzugsweise die unter Last Kraft aufnehmenden Stirnflächen 3 der Kristalle ebenfalls mit einem elektrisch leitenden Material beschichtet. Dadurch entstehen die stirnflächigen Elektroden 13. Da die seitlichen Elektroden 10 während einer Messung jeweils alternierend entgegengesetzte Ladungen enthalten, ist zwingend darauf zu achten, dass benachbarte Elektroden 10 stets isoliert voneinander sind. Zu diesem Zweck werden die seitlichen Elektroden 10 alternierend von der oberen resp. von der unteren stirnflächigen Elektrode 13 getrennt. Dies geschieht vorzugsweise durch das Anbringen einer kerbenartigen Phase 14. Dadurch sammeln sich unter Lasteinfluss jeweils positive Ladungen auf der einen Stirnfläche 3 und negative Ladungen auf der gegenüberliegenden Stirnfläche 3 des Messelementes 9 an. An diesen stirnflächigen Elektroden 13 kann die Ladungsabnahme von allen seitlichen Elektroden 10 bequem erfolgen, ohne zusätzliche Verbindungsstellen zu den Elektroden zwischen den Kristallen schaffen zu müssen. Ein derart geschaltetes Messelement eignet sich zum Messen von axial angreifenden Kräften oder Drücken.

Der Vorteil eines solchen Messelementes 9 besteht einerseits darin, dass es sich durch eine hohe Belastbarkeit und eine hohe Empfindlichkeit auszeichnet. Andererseits ist die Montage in einen Sensor, speziell die Zentrierung, sehr einfach, da das Messelement 9 aus einem einzigen Teil mit einer grossen Grundfläche besteht. Die Anordnungen der Figuren 3 und 4 hingegen bestehen aus den einzelnen Kristallen 1 und den verbindenden, federnden Elektroden 7, 8, die den Kontakt gewährleisten müssen. Da die Kristalle in der erfindungsgemässen Ausführung zudem unmittelbar nebeneinander liegen, können auf derselben Grundfläche 3 mehr Kristalle verwendet werden als bei einer Anordnung gemäss Fig. 4.

Ein weiterer Vorteil dieser Anordnung gegenüber den Ausführungen der Figuren 3 und 4 besteht darin, dass die Ladungsabnahme flächig und nicht punktuell oder entlang einer Linie verläuft. Dadurch wird verhindert, dass der elektrische Kontakt durch Abrieb, verursacht durch Vibrationen, beschädigt wird.

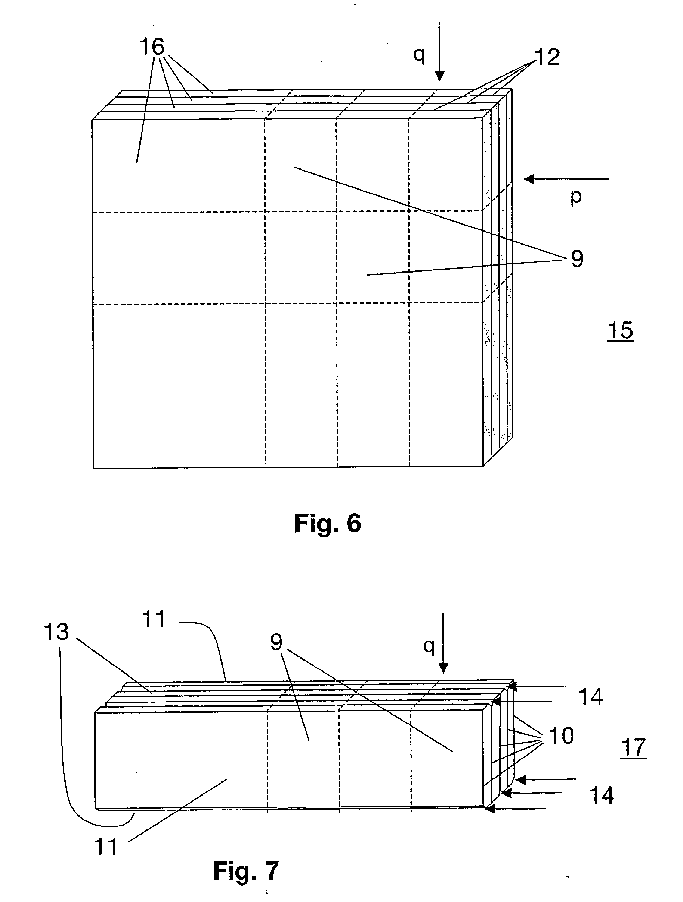

Ein weiterer Vorteil dieser Anordnung besteht in der einfachen und kostengünstigen Herstellung eines solchen erfindungsgemässen Messelementes 9, da es aus einem Wafer 15 herstellbar ist. In Fig. 6 ist ein Beispiel eines solchen Wafers 15 dargestellt. Dieser Wafer 15 besteht beispielsweise aus vier grossflächigen piezoelektrischen Kristallplatten mit Transversaleffekt 16. Diese sind mit entgegengesetzter Polarisation zueinander angeordnet und aneinander mittels einer elektrisch leitenden Schicht 12, der Elektroden, verbunden. Diese Schicht besteht vorzugsweise im Wesentlichen aus Kupfer, Gold, Silber, Platin oder Palladium oder einer Legierung daraus. Durch Schneiden des Wafers entlang den gestrichelten Linien p und q entstehen eine Vielzahl von identischen Messelementen 9.

In der Fig. 7 ist ein Teil eines Wafers 15, ein Array 17, abgebildet, der nach dem Schneiden des Wafers in einer Richtung (p) entsteht. Ein solcher Array 17 wird auf seinen vier grossen Flächen mit einer elektrisch leitenden Schicht beschichtet. Dadurch entstehen die beiden seitlichen Abschlusselektroden 11 der entstehenden Messelemente 9 sowie die stirnseitigen Elektroden 13.

Um die sich bei einer Messung verschieden aufladbaren Elektroden 10 zu trennen, werden kerbenförmige Phasen 14 am Array 17 an jeder zweiten Berührungslinie von einer seitlichen Elektrode 10 mit einer stirnseitigen Elektrode 13 angebracht, wobei jede seitliche Elektrode 10 noch genau zu einer stirnseitigen Elektrode 13 einen elektrischen Kontakt aufweist und zur anderen, dank der kerbenförmigen Phase 14, elektrisch isoliert ist. Dies gilt insbesondere auch für die beiden abschliessenden seitlichen Elektroden 11. Entlang den verbleibenden gestrichelten Linien (q) wird der Array 17 zu den fertigen Messelementen 9 geschnitten.

Solche Messelemente lassen sich einfach in Sensoren, vorzugsweise in Kraft- oder Drucksensoren, einbauen. Solche Sensoren zeichnen sich durch eine hohe Belastbarkeit und eine hohe Empfindlichkeit aus und sind zudem dank der einfachen Herstellung und Zentrierung der darin eingebrachten Messelemente kostengünstig.

### Liste der Bezeichnungen

| | |
|---|---|
| 1 | piezoelektrischer Kristall mit Transversaleffekt |
| 2 | piezoelektrisches Messelement mit Transversaleffekt |
| 3 | Stirnfläche |
| 4 | Richtung der Polarisation (Pfeilrichtungen der Fig. 1-5) |
| 5 | Querschnittsfläche |
| 6 | Dreiecksfläche |
| 7 | Spiralfeder |
| 8 | wellblechförmige Feder |
| 9 | erfinderische Ausführungsform eines Messelementes |
| 10 | seitliche Elektroden |
| 11 | seitliche Abschlusselektroden |
| 12 | Elektroden, die zwei Kristalle miteinander verbinden |
| 13 | stirnflächige Elektroden |
| 14 | kerbenartige Phase |
| 15 | Wafer |
| 16 | grossflächige piezoelektrischen Kristallplatten mit Transversaleffekt |
| 17 | Array |
| | |
| d | Dicke eines Kristalls |
| p, q | Schnittlinien |

## Patentansprüche

1. Piezoelektrisches Messelement (9) bestehend aus mindestens zwei piezoelektrischen Kristallen (1) mit Transversaleffekt zum Messen von axial angreifenden Kräften und/oder Drücken, **dadurch gekennzeichnet, dass** die Kristalle (1) mit jeweils entgegengerichteter Polarisation mittels einer seitlichen Elektrode (12) aneinander befestigt sind.

2. Messelement gemäss Anspruch 1, **dadurch gekennzeichnet, dass** die Befestigung der Elektroden (12) zu den Kristallen (1) durch Bonden, Löten oder mittels Thermokompression entstanden ist.

3. Messelement gemäss Anspruch 1 oder 2, **dadurch gekennzeichnet, dass** die Kristalle (1) plattenförmig ausgestaltet sind mit der Plattenebene senkrecht zur Polarisationsrichtung (4) und dass vorzugsweise jede Seitenfläche senkrecht zur Polarisationsrichtung (4) mit einer seitlichen Elektrode (10) beschichtet ist.

4. Messelement gemäss einem der Ansprüche 1 bis 3, **dadurch gekennzeichnet, dass** die Kraft aufnehmenden Stirnflächen (3) mit einer stirnflächigen Elektrode (13) versehen sind.

5. Messelement gemäss Anspruch 4, **dadurch gekennzeichnet, dass** jede seitliche Elektrode (10) mit genau einer stirnflächigen Elektrode (13) im elektrischen Kontakt steht, wobei alle sich unter Krafteinfluss gleich ladenden stirnflächigen Elektroden (13) in derselben Ebene liegen.

6. Messelement gemäss einem der Ansprüche 4 oder 5, **dadurch gekennzeichnet, dass** das Messelement (9) aus einem Wafer (15) entstanden ist.

7. Messelement gemäss einem der Ansprüche 4 bis 6, **dadurch gekennzeichnet, dass** die seitlichen Elektroden (10) durch kerbenartige Phasen (14) alternierend zu jeweils einer stirnflächigen Elektrode (13) elektrisch getrennt sind.

8. Messelement gemäss einem der Ansprüche 1 bis 7, **dadurch gekennzeichnet, dass** mindestens die verbindenden Elektroden (12), vorzugsweise alle Elektroden (10, 11, 12, 13) im Wesentlichen aus Kupfer, Gold, Silber, Platin oder Palladium oder einer Legierung davon bestehen.

9. Messelement gemäss einem der Ansprüche 1 bis 8, **dadurch gekennzeichnet, dass** die piezoelektrischen Kristalle (1) einen von der Temperatur unabhängigen Effekt erzielen.

10. Druck- oder Kraftsensor umfassend ein piezoelektrisches Messelement (9) nach einem der Ansprüche 1 bis 9.

## Claims

1. A piezoelectric measuring element (9) consisting of at least two piezoelectric crystals (1) with transversal effect for the measurement of axially aching forces and/or pressures **characterized in that** said crystals (1) with opposing polarization are attached to each other by means of a lateral electrode (12).

2. A measuring element according to claim 1 **characterized in that** the attachment of the electrodes (12) to said crystals (1) has been achieved by bonding, soldering or by thermocompression.

3. A measuring element according to claim 1 or 2 **characterized in that** said crystals (1) are plate-shaped wherein the plate plane is perpendicular to the direction of polarization (4), and **in that** preferably each lateral surface that is perpendicular to the direction of polarization (4) is coated with a lateral electrode (10).

4. A measuring element according to any of the claims 1 to 3 **characterized in that** the force-abaorbing end faces (3) are provided with an end face electrode (13).

5. A measuring element according to claim 4 **characterized in that** each lateral electrode (10) is in electric contact with exactly one end face electrode (13) wherein all end face electrodes (13) that acquire the same charge under the influence of force lie in the same plane.

6. A measuring element according to any of the claims 4 or 5 **characterized in that** the measuring element (9) has been obtained from a wafer (15).

7. A measuring element according to any of the claims 4 to 6 **characterized in that** the lateral electrodes (10) are electrically separated by notch-like phases (14) each alternating with one end face electrode (13).

8. A measuring element according to any of the claims 1 to 7 **characterized in that** at least the connecting electrodes (12), and preferably all electrodes (10, 11, 12, 13) are essentially made of copper, gold, silver, platinum or palladium or an alloy thereof.

9. A measuring element according to any of the claims 1 to 8 **characterized in that** the piezoelectric crystals (1) achieve a temperature-independent effect.

10. A pressure or force sensor comprising a piezoelectric measuring element (9) according to any of the claims 1 to 9.

## Revendications

1. Un élément de mesure piézoélectrique (9) constitué d'au moins deux cristaux piézoélectriques (1) à effet transversal destiné à mesurer des forces et/ou pressions agissant de façon axiale **caractérisé en ce que** lesdits cristaux (1) de polarisations opposées sont liés l'un à l'autre par l'intermédiaire d'une électrode latérale (12).

2. Un élément de mesure selon la revendication 1 **caractérisé en ce que** la liaison des électrodes (12) auxdits cristaux (1) a été réalisée par collage, soudage ou bien par thermocompression.

3. Un élément de mesure selon la revendication 1 ou 2 **caractérisé en ce que** lesdits cristaux (1) sont en forme de plaques, le plan de la plaque étant perpendiculaire à la direction de polarisation (4), et **en ce que** préférablement chacune surface latérale qui est perpendiculaire à la direction de polarisation (4) est revêtue avec une électrode latérale (10).

4. Un élément de mesure selon l'une quelconque des revendications 1 à 3 **caractérisé en ce que** les faces frontales (3) absorbant des forces sont fournies d'une électrode de face frontale (13).

5. Un élément de mesure selon la revendication 4 **caractérisé en ce que** chacune électrode latérale (10) est en contact électrique avec exactement une électrode de face frontale (13) dans lequel toutes les électrodes de faces frontales (13) acquérant la même charge sous l'influence d'une force se trouvent dans le même plan.

6. Un élément de mesure selon l'une quelconque des revendications 4 ou 5 **caractérisé en ce que** ledit élément de mesure (9) a été obtenu d'une plaquette de silicium (15).

7. Un élément de mesure selon l'une quelconque des revendications 4 à 6 **caractérisé en ce que** les électrodes latérales (10) sont séparées l'une de l'autre électriquement par des phases (14) en forme d'encoches chacune alternant avec une électrode de face frontale (13).

8. Un élément de mesure selon l'une quelconque des revendications 1 à 7 **caractérisé en ce qu'**au moins les électrodes de raccordement (12) et préférablement toutes les électrodes (10, 11, 12, 13) se composent essentiellement de cuivre, d'or, d'argent, de platine ou de palladium ou de leurs alliages.

9. Un élément de mesure selon l'une quelconque des revendications 1 à 8 **caractérisé en ce que** lesdits cristaux piézoélectriques (1) obtiennent un effet indépendamment de la température.

10. Un capteur de pression ou de force comprenant un élément de mesure piézoélectrique (9) selon l'une quelconque des revendications 1 à 9.
